# EUROPEAN PATENT APPLICATION

(11) **EP 0 716 445 A2**
(43) Date of publication of application: **12.06.1996**
(21) Application number: 95308873.9
(22) Date of filing: 07.12.1995
(51) Int. Cl.: H01L 23/495, H01L 23/24

(54) **Semiconductor device**

(30) Priority: 08.12.1994 JP 304722/94
(71) Applicant: FUJI ELECTRIC CO. LTD., Kawasaki 210 (JP)
(72) Inventor: Soyano, Shin, Kawasaki-ku, Kawasaki 210 (JP); Toba, Susuma, Kawasaki-ku, Kawasaki 210 (JP)
(74) Representative: Topley, Paul

(57) **Abstract**

To provide a semiconductor device that has a highly reliable installation structure of the lead frames, the coupling protrusions thereof do not rattle in the coupling holes of the insulating case frame even if the dimensions of the elliptical coupling holes are only approximately controlled, the coupling protrusions (81c, 81c) are twisted in the opposite directions from one another by the angle of torsion θ. The head of each protrusion (81c) is widened to be elliptical. The lead frame (81) is installed with its coupling protrusions (81c, 81c) inserted in the elongated coupling holes (C) formed on the third step (16) of the resin frame portion (12).

## Description

The present invention relates to semiconductor devices called 'power modules' which house a circuit board whereon semiconductor elements are mounted in an insulating case frame, and more specifically the present invention relates to a structure for installing lead frames.

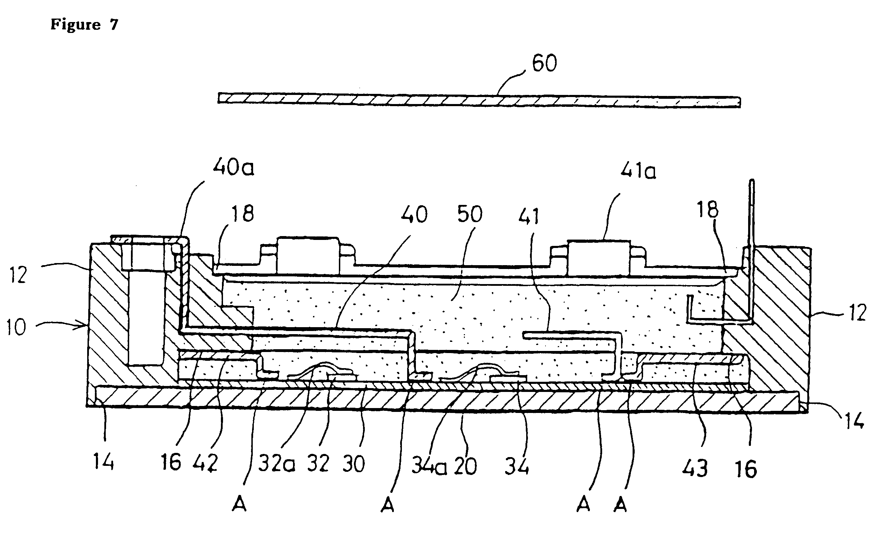

Figure 7 is a cross section showing the general structure of a semiconductor device called a 'power module' or an 'intelligent power module'. As shown in Figure 7, the semiconductor device has an insulating case frame 10, having a frame portion 12. A heat-dissipating base plate 20 (in this embodiment a metal plate) is bonded with an adhesive to a rebate or step 14 surrounding a first opening formed on a first side of the frame portion 12 to close the first opening of the case frame 10. A circuit board (ceramics board) 30 is bonded with a soldered joint or the like to the inside face of the radiator base plate 20. Lead frames 40 to 43 are connected at their inner lead ends A to the thick film wiring formed on the circuit board 30. The circuit board 30 and the inner leads of the lead frames 40 to 43 are immersed in a gel resin sealant (silicone resin) 50. An insulating cover plate 60 is bonded with an adhesive to a second opening step 18 formed on a second side of the frame portion 12 to close the second opening of the case frame 10. Semiconductor elements (chips) 32, 34 such as power transistors, IGBTs (conductivity modulation-type transistors), diodes, thyristors, etc. are mounted on the circuit board 30. The inner lead ends A of the lead frames 40 to 43 are bonded with a solder etc. to the land portions of the thick film wiring of the circuit board 30, and are connected to bonding wires 32a, 34a leading to the corresponding semiconductor elements 32, 34. The lead frames 40 and 41 for external connection are inserted into the frame portion 12 and fixed to the frame portion 12 at respective terminal washers 40a and 41a with terminal screws (not shown) to accept external connections.

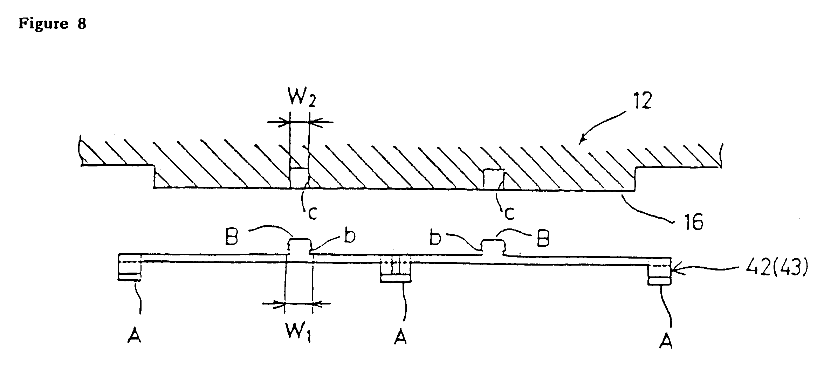

Figure 8 is a cross-section showing the installation of the lead frames of the semiconductor device of Figure 7. As shown in Figure 8, the lead frame 42 (43) for connecting together a plurality of electrodes on the circuit board (for internal power supply) is installed with its coupling protrusions B pressed into elongated coupling holes C formed on a third step 16 of the resin frame portion 12. Saw teeth b are formed on the side faces of the coupling protrusions B that engage with the walls of the coupling holes C to anchor the coupling protrusions B thereto.

The installation structure of the lead frames 42 and 43 for internal connection in the above described semiconductor device has the disadvantage that the coupling protrusion B is designed so that the coupling protrusion B, once pressed into the slit-shaped coupling hole C of the resin frame portion 12, may engage with the wall of the coupling hole C and may not come out from the coupling hole C. It is necessary to set the width W1 (e.g. several mm) of the coupling protrusion B so that it is wider than the length W2 of the coupling hole C. If the width W1 of the coupling protrusion B exceeds the length W2 of the coupling hole C by too great an amount, it will be difficult to press the coupling protrusion B into the coupling hole C. Therefore, the width W1 of the coupling protrusion B and the length W2 of the coupling hole C must be strictly controlled. Since the coupling hole C is formed by resin moulding, deviations are caused in the length W2 of the coupling hole C by the shrinkage etc. of the resin. The deviations of the length W2 make it either difficult to press the coupling protrusion B into the coupling hole C, or cause play between the coupling protrusion B and the coupling hole C. Thus, the deviations of the length W2 reduce the production yield of the semiconductor devices.

In view of the foregoing, it is an object of the invention to provide a semiconductor device that has a highly reliable installation structure for the lead frames, and wherein the coupling protrusions do not rattle in the coupling holes of the insulating case frame even if the dimensions of the elongated coupling holes are only approximately controlled.

According to an aspect of the present invention, there is provided a semiconductor device that comprises: lead frames including coupling protrusions formed thereon, and inner leads, the neighbouring coupling protrusions being twisted in the opposite directions from one another; an insulating case frame including a frame portion having a step whereon are formed elongated coupling holes into which the coupling protrusions are inserted; a base plate covering a first opening of the insulating case frame; a circuit board on which semiconductor chips connected to the ends of the inner leads are mounted, the circuit board being bonded to the inner face of the base plate; a gel resin sealant in which the circuit board and the inner leads are immersed, the gel resin sealant filling the interior space of the insulating case frame; and an insulating cover plate closing a second opening of the insulating case frame. It is preferable to widen the heads of the coupling protrusion to make them elliptical.

According to another aspect of the invention, the coupling protrusions are V-shaped in longitudinal cross section.

In an early stage of pressing the coupling protrusions, which are twisted in the opposite directions from one another, into the elongated coupling holes, the heads of the coupling protrusions are once twisted back in the directions which reduce the angle of torsion. After being completely pressed into the elongated coupling holes, the side edges of the coupling protrusions engage the sides of the coupling holes to be tightly coupled with the elongated coupling holes by the elastic force of the restoring torsion. Thus, the coupling protrusions, pressed into the elongated coupling holes, do not rattle in the elongated coupling holes. Since the elliptical head of each coupling protrusion is smoothly inserted into the elongated coupling hole, the operation of pressing the coupling protrusion into the elongated coupling holes is facilitated.

The elliptical heads of the coupling protrusions are inserted smoothly into the coupling holes, and therefore, it is facilitated to press the coupling protrusions into the coupling holes.

The V-shaped coupling protrusions are once flattened during the insertion into the coupling holes. After being completely inserted into the coupling holes, the coupling protrusions are bent back to expand across the coupling holes by the elastic restoring force that decreases the angle of the V-shape, so that the side edges of the protrusions engage one side of the elongate coupling holes, and the apex of the 'V' engages the other side of the hole. In this structure too, the lead frames are tightly mounted on the semiconductor device without rattling.

The preferred embodiments of the invention present invention will now be explained in detail, with reference to the accompanying drawings, in which:
Figure 1 is a top plan view, showing an insulating case frame having lead frames thereon, of an embodiment of a semiconductor device according to the present invention;
Figure 2 is an underneath plan view of the insulating case frame of Figure 1;
Figure 3(a) is a cross section along the line A-A' of Figure 1;
Figure 3(b) is a cross section along the line B-B' of Figure 1;
Figure 4(a) is a top plan view of a lead frame of according to the invention;
Figure 4(b) is a front view of the lead frame of Figure 4(a);
Figure 4(c) is a side view of the lead frame of Figure 4(a);
Figure 5(a) is a top plan view of another lead frame of according to the invention;
Figure 5(b) is a front view of the lead frame of Figure 5(a);
Figure 5(c) is a side view of the lead frame of Figure 5(a);
Figure 6 is an exploded isometric view showing the installation structure for the lead frames of the invention;
Figure 7 is a cross-section showing the conventional structure of a semiconductor device called a power module or an intelligent power module; and
Figure 8 is a cross-section showing the installation of the lead frames of the semiconductor device of Figure 7.

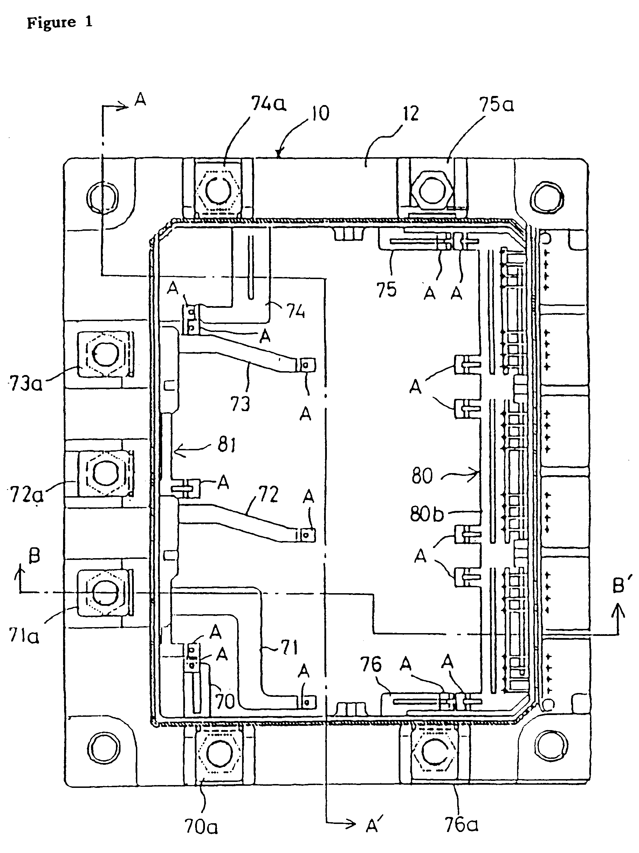

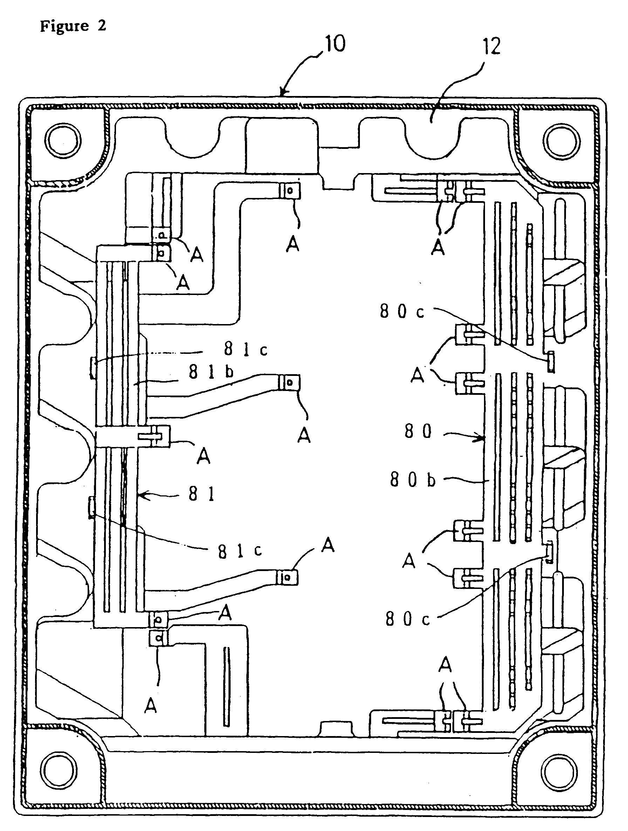

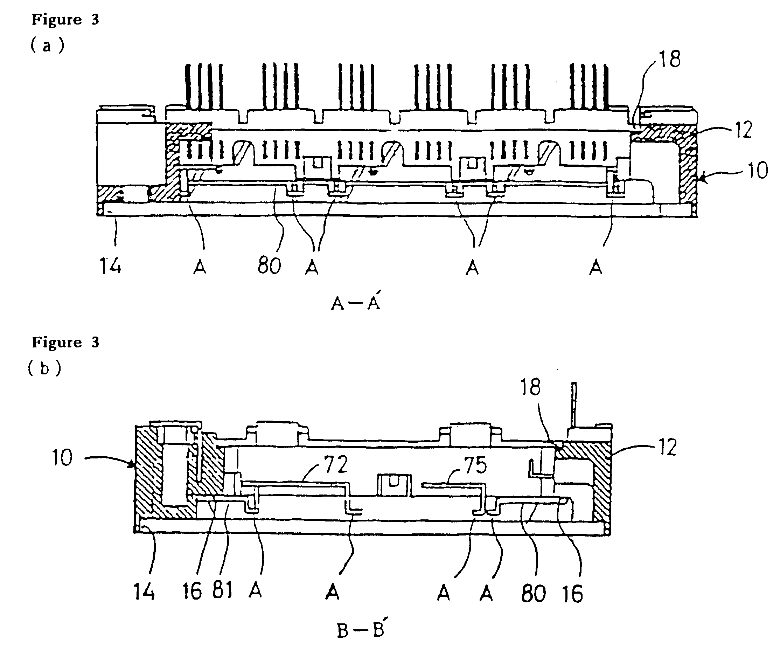

Referring now to the drawings, Figure 1 is a top plan view of an embodiment of a semiconductor device according to the present invention, showing an insulating case frame having lead frames thereon. Figure 2 is a bottom plan view of the insulating case frame of Figure 1, and Figures 3(a) and 3(b) are cross-sections taken along the line A-A' and along the line B-B' of Figure 1, respectively.

The semiconductor device of the invention is called a 'power module' or an 'intelligent power module'. The semiconductor device has an insulating case frame 10 that has a frame portion 12. A heat dissipating radiator base plate (not shown) is bonded with an adhesive to a rebate or step 14 surrounding a first opening formed on a first side of the frame portion 12 to close the first opening of the case frame 10. A circuit board (not shown) is bonded with solder or the like to the inside face of the base plate. Lead frames 70 to 76, 80, and 81 are connected at their inner lead ends A to the thick film wiring formed on the circuit board. The circuit board and inner leads of the lead frames are immersed in a gel resin sealant (not shown), similar to the silicone resin 50 seen in Figure 7. An insulating cover plate (not shown) is bonded with an adhesive to a second opening step 18 formed on a second side of the frame portion 12 to close the second opening of the case frame 10. As described earlier, semiconductor chips such as power transistors, IGBTs (conductivity modulation-type transistors), diodes, thyristors, etc. are mounted on the circuit board. Though not shown in the Figure, the lead ends A of the lead frames 70 to 76, 80 and 81 are bonded with a solder etc. to the land portions of the thick film wiring of the circuit board. The lead frames 70 to 76 for external connection are inserted into the frame portion 12 and fixed to the frame portion 12 at respective terminal washers 70a to 76a with terminal screws for accepting external connections (not shown).

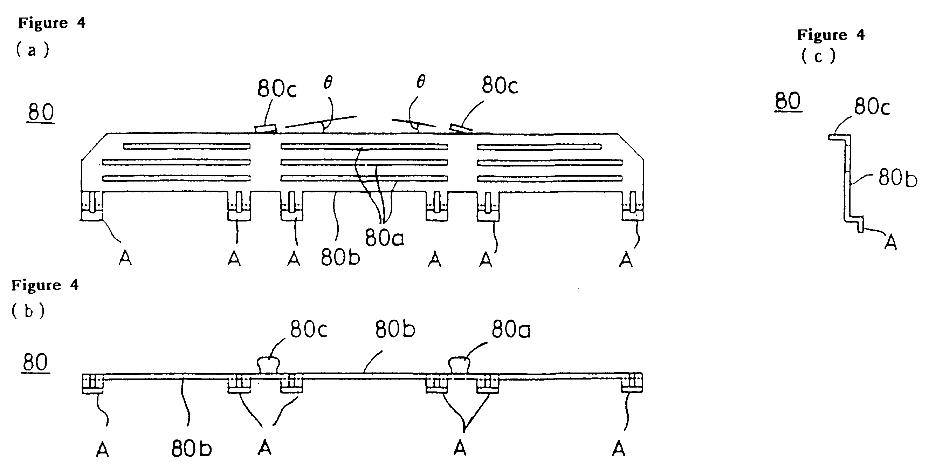

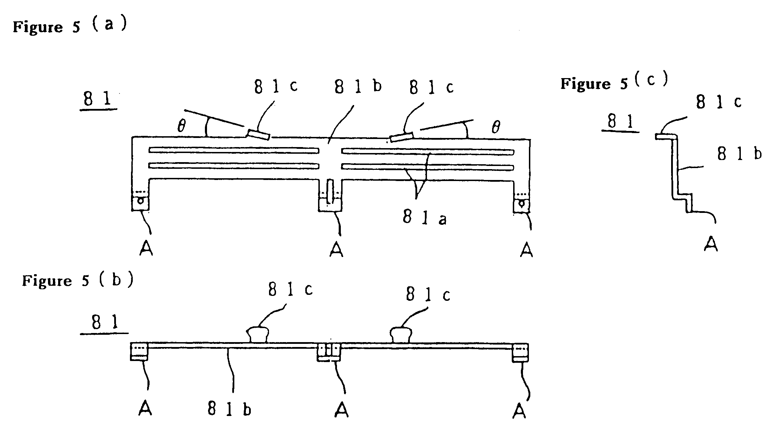

Figure 4(a) is a top plan view, Figure 4(b) a front view, and Figure 4(c) a side view of the lead frame 80. Figure 5(a) is a top view, Figure 5(b) a front view, and Figure 5(c) a side view of the lead frame 81. The lead frames 80, 81 for mutually connecting a plurality of electrodes on the circuit board (for internal power supply) are shaped as shown in Figures 4(a) to 4(c) and in Figures 5(a) to 5(c).

Referring now to Figures 4(a) to 4(c), the lead frame 80 has a frame 80b in which is formed a plurality of slits 80a. Lead ends A are extended sideways and bent downward from a first long side of the frame 80b, and a pair of coupling protrusions 80c, 80c extend downward from a second long side of the frame 80b. The coupling protrusions 80c, 80c are twisted by an angle of torsion θ in opposite senses from one another. The head of each coupling protrusion 80c is widened and elliptically shaped. In a similar manner, and as shown in Figures 5(a) to 5(c), the lead frames 81 have a frame 81b in which is formed a plurality of slits 81a. Lead ends A extend sideways and are bent downward from a first long side of the frame 81b, and a pair of coupling protrusions 81c, 81c extend downward from a second long side of the frame 81b. The coupling protrusions 81c, 81c are twisted by an angle of torsion θ in opposite directions from one another. The head of each coupling protrusion 81c is widened and shaped in the form of an ellipse.

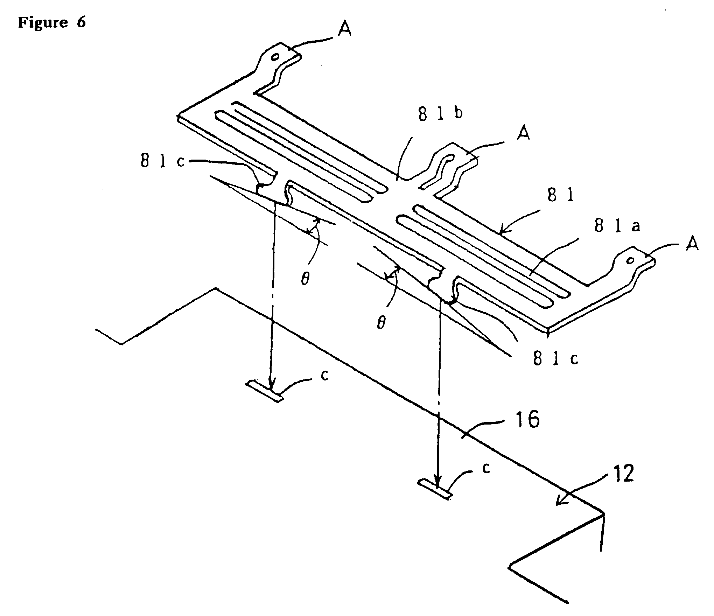

Figure 6 is an exploded isometric view showing the installation structure for the lead frames of the invention. As shown in the Figure, the lead frame 81 is installed with its coupling protrusions 81c pressed into the elongated coupling holes C formed on a third step 16 of the resin frame portion 12. The lead frame 80 is also installed in a similar manner.

In an early stage of pressing the coupling protrusions 80c or 81c into the elongated coupling holes C, the heads of the coupling protrusions, which are twisted in the opposite directions from one another, are initially twisted back in the directions which reduce the angle of torsion. After the coupling protrusions 80c and 81c are completely pressed into the elongated coupling holes C, the side edges of the coupling protrusions 80c and 81c engage tightly with the sides of the elongated coupling holes C by the elastic force of the restoring torsion. Thus, the coupling protrusions 80c and 81c do not rattle in the elongated coupling holes C. Since the elliptical heads of the coupling protrusions 80c and 81c are smoothly inserted into their respective elongated coupling holes C, the operation of pressing the coupling protrusions into the elongated coupling holes C is facilitated.

As an alternative to forming the neighbouring coupling protrusions twisted in opposite directions from one another and forming the coupling holes in longitudinal alignment, the coupling protrusions may be formed as coplanar protrusions and the elongated coupling holes may be formed in the twisted positions with respect to the untwisted coupling protrusions. As a further alternative, the protrusions may be parallel but not coplanar, and the holes may be coplanar, so that during entry of the protrusions into the holes the protrusions are twisted in the same sense. It is also envisaged that other relative orientations of the planes of the protrusions relative to the planes of the slots can be adopted, provided that the protrusions are caused to elastically deform in torsion during entry into the holes.

As a further alternative, the longitudinal cross section of the neighbouring coupling protrusions may be V-shaped. By arranging for the included angle of the V-shape to be increased during an early stage of pressing the coupling protrusions into the coupling holes, the coupling protrusions can elastically restore, when completely inserted into the coupling holes, to expand laterally relative to the coupling holes. Therefore, the coupling protrusions are installed tightly on the insulating case frame without rattling, the side edges and apex of each protrusion engaging with the sides of its coupling hole.

As has been explained so far, the semiconductor device of the invention utilises the elastic restoring force to prevent the coupling protrusions from coming out of the coupling holes. Therefore, the semiconductor device of the invention exhibits the following effects.

The coupling protrusions, when completely inserted in their respective coupling holes, are expanded laterally by the elastic restoring torsional force across the coupling holes and engage tightly with the coupling holes. Therefore, the lead frames are tightly mounted on the semiconductor device without rattling.

By shaping the head of each coupling protrusion as an ellipse, the elliptical heads can be inserted smoothly into the coupling holes. Therefore, pressing the coupling protrusions into the coupling holes is facilitated.

The V-shaped protrusions are arranged so as to be initially flattened during the insertion into the coupling holes. When completely inserted into the coupling holes, the coupling protrusions are urged back to expand across the coupling holes by the elastic restoring force that decreases the included angle of the V-shaped cross-section. In this structure too, the lead frames are tightly mounted on the semiconductor device without rattling.

## Claims

1. A semiconductor device comprising:
lead frames including generally planar coupling protrusions formed thereon, and inner leads, the planes of neighbouring coupling protrusions being twisted in opposite directions from one another;
an insulating case frame including a frame portion having a step whereon are formed aligned elongated coupling holes into which the coupling protrusions are inserted;
a base plate covering a first opening of the insulating case frame;
a circuit board on that are mounted semiconductor chips connected to the ends of the inner leads, the circuit board being bonded to the inner face of the base plate;
a gel resin sealant in that are immersed the circuit board and the inner leads, the gel resin sealant filling the inside space of the insulating case frame; and
an insulating cover plate closing a second opening of the insulating case frame.

2. The semiconductor device of claim 1, wherein the heads of the coupling protrusion are widened to be elliptical.

3. A semiconductor device comprising:
lead frames including coupling protrusions V-shaped in the longitudinal cross section thereof, and inner leads;
an insulating case frame including a frame portion having a step whereon are formed elongated coupling holes into which the coupling protrusions are inserted;
a base plate covering a first opening of the insulating case frame;
a circuit board on that are mounted semiconductor chips connected to the ends of the inner leads, the circuit board being bonded to the inner face of the base plate;
a gel resin sealant in that are immersed the circuit board and the inner leads, the gel resin sealant filling the inside space of the insulating case frame; and
an insulating cover plate closing a second opening of the insulating case frame.

4. A semiconductor device comprising:
lead frames including generally planar coupling protrusions formed thereon, and inner leads, the planes of the coupling protrusions being in a first relative orientation to one another;
an insulating case frame including a frame portion having a step whereon are formed aligned elongated coupling holes into which the coupling protrusions are inserted, the planes of the coupling holes being in a second relative orientation to one another;
the arrangement of the coupling protrusions and the coupling holes being such that during insertion of the coupling protrusions into the coupling holes elastic deformation of the protrusions causes twisting of the protrusions towards alignment of their planes with the planes of their respective elongate coupling holes.
